# FASCICULE DE BREVET EUROPEEN

(11) **EP 3 258 510 B1**
(45) Date de publication et mention de la délivrance du brevet: **10.04.2019**
(21) Numéro de dépôt: 17175157.1
(22) Date de dépôt: 09.06.2017
(51) Int. Cl.: H01L 51/40, H01L 21/265

(54) **PROCÉDÉ DE FABRICATION D'UN CONTACT ÉLECTRIQUE SUR UNE STRUCTURE**
HERSTELLUNGSVERFAHREN EINES ELEKTRISCHEN KONTAKTS AUF EINER STRUKTUR
METHOD FOR MANUFACTURING AN ELECTRICAL CONTACT ON A STRUCTURE

(30) Priorité: 13.06.2016 FR 1655432
(43) Date de publication de la demande: 20.12.2017
(73) Titulaire: Commissariat à l'énergie atomique et aux énergies alternatives, 75015 Paris (FR)
(72) Inventeur: RAMOS, Raphaël, 38100 GRENOBLE (FR); DIJON, Jean, 38800 CHAMPAGNIER (FR)
(74) Mandataire: Brevalex

(56) Documents cités:
- US-B1- 8 604 459
- ADRIEN ALLAIN ET AL: "Electrical contacts to two-dimensional semiconductors", NATURE MATERIALS, vol. 14, no. 12, 20 novembre 2015 (2015-11-20), pages 1195-1205, XP055354723, GB ISSN: 1476-1122, DOI: 10.1038/nmat4452
- U. BANGERT ET AL: "Doping of few-layered graphene and carbon nanotubes using ion implantation", PHYSICAL REVIEW. B, CONDENSED MATTER AND MATERIALS PHYSICS, vol. 81, no. 24, 1 juin 2010 (2010-06-01), XP055353996, US ISSN: 1098-0121, DOI: 10.1103/PhysRevB.81.245423
- U. BANGERT ET AL: "Ion Implantation of Graphene-Toward IC Compatible Technologies", NANO LETTERS, vol. 13, no. 10, 9 octobre 2013 (2013-10-09), pages 4902-4907, XP055353925, US ISSN: 1530-6984, DOI: 10.1021/nl402812y

## Description

### DOMAINE TECHNIQUE

L'invention concerne un procédé de fabrication d'un contact électrique sur une structure. Plus particulièrement, l'invention concerne un procédé de réalisation d'un contact électrique sur une structure faite d'un matériau présentant une conductivité électrique anisotrope.

### ÉTAT DE LA TECHNIQUE ANTÉRIEURE

Les structures faites de matériaux présentant des propriétés de conductivité électrique anisotropes, tels que les nanotubes de carbone, sont très prometteuses pour des applications dans les domaines de la microélectronique, de la spintronique, de l'optoélectronique, des capteurs, ou encore des électrodes transparentes conductrices.

Cependant, la connexion de ces structures au monde extérieur à l'aide d'électrodes peut présenter certaines difficultés. Effectivement, quand bien même la réalisation d'électrodes présentant une faible résistivité de contact sur des matériaux comme le silicium est bien maîtrisée par l'homme du métier, la réalité est tout autre dès lors que la structure est faite d'un matériau anisotrope et présente une anisotropie de conductivité électrique (ci-après dénommé « matériau anisotrope »).

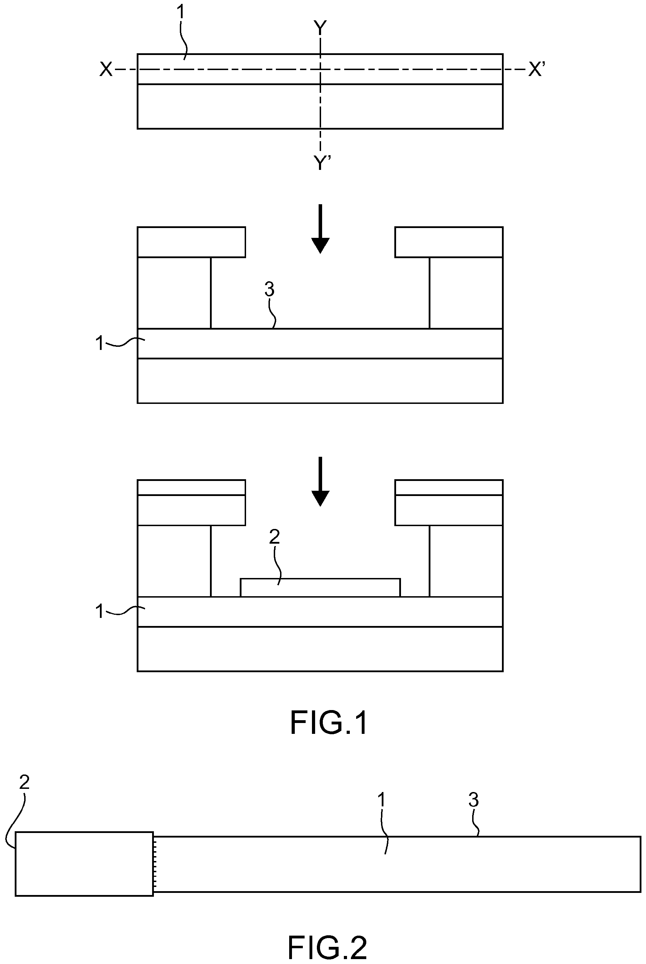

En effet, la figure 1 illustre un procédé de fabrication, connu de l'état de la technique, d'une électrode 2 sur une structure 1 faite d'un matériau anisotrope NA présentant une conductivité électrique anisotrope. L'électrode 2 peut, par exemple, être une électrode métallique. La structure 1 présente une conductivité électrique axiale σ_{//} selon un premier axe XX' de la structure 1, et au moins une conductivité électrique orthogonale σ_{⊥} selon au moins une direction orthogonale YY' au premier axe XX' de la structure 1. L'au moins une conductivité électrique orthogonale σ_{⊥} est inférieure à la conductivité électrique axiale σ_{//}. Le procédé comprend une étape de formation d'une électrode 2, d'une épaisseur initiale Eᵢ, comprenant par exemple une espèce M, sur une première surface 3 de la structure 1, la première surface 3 étant orthogonale à l'au moins une direction orthogonale YY'.

Selon ce procédé connu de l'état de la technique, la structure 1 s'étend selon le premier axe XX'.

La conductivité électrique orthogonale σ_{⊥} selon la direction orthogonale YY' à la première surface 3 est généralement très faible. Par ailleurs, la première surface 3 est, généralement, chimiquement inerte selon la direction orthogonale YY' à ladite surface.

Autrement dit, la première surface 3 ne forme pas de liaisons chimiques selon la direction perpendiculaire à ladite première surface 3. Ainsi, dès lors qu'une électrode 2 est formée sur la première surface 3, une barrière énergétique (barrière tunnel) élevée au passage d'un courant électrique entre l'électrode 2 et la première surface 3 peut être observée. Cette barrière énergétique élevée se traduit par une résistance électrique de contact, entre l'électrode 2 et la première surface 3, élevée.

A cet égard, le matériau anisotrope NA peut comprendre du graphène, un nanotube de carbone ou un faisceau de nanotubes de carbone. La première surface 3 comprend donc des atomes de carbone arrangés selon une maille cristallographique hexagonale chimiquement inerte.

Afin de pallier ce problème, il a été proposé de réaliser l'électrode 2 selon un plan ou une surface perpendiculaire au premier axe XX' de la structure 1. A cet égard l'homme du métier peut consulter le document [1] cité à la fin de la demande de brevet.

La figure 2 illustre un tel cas de figure. Nous parlons alors de contact par la tranche (« Edge Contact » selon la terminologie Anglo-Saxonne). Cependant, un vrai contact par la tranche reste difficile à mettre en oeuvre.

Par conséquent, les contacts par le dessus sont de loin les plus utilisés, d'une part car ils sont techniquement plus simples à réaliser qu'un contact par la tranche, et d'autre part car il est très difficile de réaliser un vrai contact par la tranche.

Ainsi, afin d'améliorer les performances des contacts métalliques par le dessus, il a été proposé d'intercaler un matériau d'interface entre le matériau anisotrope et l'électrode. Par exemple, dans le cas d'un matériau anisotrope NA en graphène, le matériau d'interface est avantageusement du graphite [2], tandis que le molybdène [3, 4] constitue une interface de choix dès lors que le matériau anisotrope est du MoS₂.

Or, cette approche nécessite de faire un choix approprié du matériau d'interface en fonction de la nature de l'électrode 2 et du matériau anisotrope NA considérés pour atteindre les performances désirées. Aussi, un tel matériau d'interface peut ne pas être disponible ou requérir des conditions de mise en oeuvre incompatibles avec la nature de la structure 1 (par exemple le matériau peut nécessiter des hautes températures pour sa formation).

De manière alternative, il a été proposé, dans le cas du graphène, de conférer un caractère de « contact par la tranche » à un contact par le dessus.

Les méthodes alternatives comprennent, préalablement à la formation du contact métallique, la formation de trous dans le graphène sous le contact.

A cet égard, l'homme du métier pourra se référer aux documents [5], [6] et [7] cités à la fin de la demande de brevet.

Dans le document [5], des cavités sont formées au niveau de la première surface 3 de sorte que l'électrode 2 « pénètre » dans le volume de la structure 1.

Cependant, la formation des cavités requiert l'emploi d'une étape de photolithographie qui du fait de sa résolution ne permet pas de former des électrodes de petite taille, par exemple inférieure à 50 nm. Par ailleurs, cette technique ne peut pas être facilement mise en oeuvre sur une structure 1 faite de nanotubes de carbone.

L'approche proposée dans le document [6] met également en oeuvre un procédé de formation de cavités à partir de la première surface 3 par un procédé de gravure avec des nanoparticules de nickel. Cependant, ce procédé ne peut être réalisé sur des dichalcogénures de métaux de transition (par exemple MoS₂).

Enfin l'approche proposée dans le document [7] met en oeuvre un traitement de la première surface 3 par un plasma d'oxygène avant la formation de l'électrode. Cette méthode ne s'applique donc qu'aux nanomatériaux carbonés et peut difficilement être mise en oeuvre dans le cas de matériaux composés bidimensionnels, par exemple.

Un but de l'invention est alors de proposer un procédé de fabrication d'un contact électrique par le dessus sur une structure comprenant un matériau anisotrope NA, et présentant une résistivité d'interface, entre l'électrode et la structure, plus faible que ce qui est connu de l'état de l'art.

Un autre but de l'invention est de proposer un procédé de fabrication d'un contact électrique compatible avec les techniques de micro fabrication connues de l'homme du métier.

Un autre but de l'invention est également de proposer un procédé de fabrication d'un contact électrique qui peut être mis en oeuvre pour des nanotubes de carbone, du graphène, des dichalcogénures de métaux de transition, des matériaux bidimensionnels, et des hétérostructures de Van der Waals.

### EXPOSÉ DE L'INVENTION

Les buts de l'invention sont, au moins en partie, atteints par un procédé de fabrication d'un contact électrique sur une structure faite d'un matériau anisotrope NA présentant une conductivité électrique anisotrope, la structure présentant une conductivité électrique axiale σ_{//} selon un premier axe XX' de la structure, et au moins une conductivité électrique orthogonale σ_{⊥} selon au moins une direction orthogonale YY' au premier axe XX' de la structure, l'au moins une conductivité électrique orthogonale σ_{⊥} étant inférieure à la conductivité électrique axiale σ_{//}, le procédé comprenant :
- une étape de formation d'une électrode, d'une épaisseur initiale Eᵢ, comprenant au moins une espèce M, sur une première surface de la structure, la première surface étant orthogonale à l'au moins une direction orthogonale YY' ;
l'étape de formation de l'électrode est suivie d'une étape d'implantation d'espèces X, au travers de l'électrode, dans la structure.

Ainsi, l'étape d'implantation permet de déstructurer, au moins en partie, le volume de la structure implanté. Par déstructurer, nous entendons briser des liaisons chimiques et générer du désordre atomique dans la structure.

Contrairement aux procédés connus de l'état de la technique, l'interface formée par l'électrode et la structure selon l'invention est diffuse (autrement dit, elle n'est plus abrupte). Cet effet est particulièrement avantageux dans le cas de structures présentant une forte anisotropie de conductivité électrique et une épaisseur élevée selon une direction orthogonale à la première surface (cas des faisceaux de nanotubes de carbone et des hétérostructures de Van der Waals). En effet, dès lors que le contact électrique est réalisé selon l'invention, une partie plus importante du volume de la structure participe à la conduction électrique. En effet, selon l'invention, une partie plus importante de cristaux sont connectés à l'électrode. Cet effet permet d'envisager une réduction de la taille de l'électrode par rapport à ce qui est connu de l'état de la technique (par réduction de la taille de l'électrode, nous entendons également une réduction de la portion de la première surface recouverte par l'électrode).

Par ailleurs, la présence de l'électrode lors d'étape d'implantation permet de protéger la structure. En effet, à titre d'exemple, la Demanderesse a constaté que les nanotubes de carbone sont détruits au moins localement (au niveau du volume implanté) s'ils sont implantés avant la formation de l'électrode.

En outre, le procédé selon l'invention nécessite des conditions de nettoyage moins sévères avant la formation de l'électrode. En effet, l'étape d'implantation favorise un contact plus intime entre l'électrode et la structure. Cet effet est particulièrement avantageux dans le cas d'une structure faite de nanotubes de carbone ou de graphène dont la contamination en produits carbonés est très difficile à réduire. Le procédé selon l'invention est par conséquent moins sensible à la contamination.

Selon un mode de réalisation, l'étape d'implantation des espèces X est réalisée exclusivement au travers de l'électrode.

Ainsi, un masque présentant une ouverture en correspondance avec l'électrode peut être disposé sur la structure pendant l'étape d'implantation des espèces X.

Selon un mode de réalisation, l'espèce M est implantée par recul dans la structure lors de l'étape d'implantation d'espèces X.

Selon un mode de réalisation, l'espèce M est adaptée pour former des liaisons chimiques avec le matériau anisotrope NA.

La formation de liaisons chimiques entre l'espèce M et le matériau anisotrope permet une injection efficace d'électrons dans la structure, à l'instar des contacts par la tranche décrits précédemment.

Selon un mode de réalisation, les espèces X sont adaptées pour former des liaisons chimiques avec le matériau anisotrope NA.

Selon un mode de réalisation, les espèces X et l'espèce M sont de même nature chimique, avantageusement identiques.

Selon un mode de réalisation, l'étape d'implantation est exécutée selon une énergie d'implantation des espèces X, conférant auxdites espèces X une énergie suffisante pour traverser la structure, lorsqu'elle est dépourvue d'électrode, dans son intégralité au travers de la première surface, et selon une direction orthogonale YY' à ladite première surface.

Selon un mode de réalisation, l'étape d'implantation des espèces X est exécutée de sorte qu'à l'issue de ladite étape, l'électrode M présente une épaisseur résiduelle non nulle, et inférieure à l'épaisseur initiale Eᵢ et à la profondeur d'implantation Rp des espèces X dans l'électrode conductrice.

Selon un mode de réalisation, l'étape d'implantation des espèces X est suivie d'une étape comprenant l'épaississement de l'électrode.

Selon un mode de réalisation, le matériaux anisotrope NA comprend au moins un des matériaux choisi parmi : un nanotube de carbone isolé, un faisceau de nanotubes de carbone, du graphène (mono- ou multicouche, ainsi que ses dérivés), de dichalcogénure de métaux de transition, des matériaux bidimensionnels semi-conducteurs, des hétérostuctures de Van der Waals.

Selon un mode de réalisation, l'espèce M comprend au moins un des éléments choisis parmi : Pd, Au, Ti, Ta, Cr, Al, Mo, Co, W, Ni, Pt, Zr, Nb, Ga, In, Bi.

Selon un mode de réalisation, l'épaisseur initiale Eᵢ est comprise entre 0,1 nm et 50 nm.

Selon un mode de réalisation, les espèces implantées X comprennent au moins un des éléments choisis parmi : Pd, Au, Ti, Ta, Cr, Al, Mo, Co, W, Ni, Pt, Zr, Nb, Ga, In, Bi, Ar, Kr, Xe, S, Se, Te.

Selon un mode de réalisation, l'étape d'implantation des espèces X est réalisée à une énergie d'implantation comprise entre 0,1 et 1000 keV.

Selon un mode de réalisation, l'étape d'implantation des espèces X est réalisée selon une dose d'espèces X comprise entre 10¹⁰ et 10¹⁸ ions par cm².

Selon un mode de réalisation, l'étape d'implantation des espèces X est suivie d'un recuit thermique exécuté à une température comprise entre 300 et 500°C, sous une atmosphère inerte ou réductrice.

### BRÈVE DESCRIPTION DES DESSINS

D'autres caractéristiques et avantages apparaîtrons dans la description qui va suivre des modes de mise en oeuvre du procédé de fabrication selon l'invention, donnés à titre d'exemples non limitatifs, en référence aux dessins annexés dans lesquels :
- la figure lest une représentation schématique d'un procédé de fabrication d'un contact électrique sur une structure connu de l'état de la technique,
- la figure 2 est une représentation schématique d'un contact métallique par la tranche sur une structure, obtenu par un procédé connu de l'état de la technique,
- la figure 3 est une représentation schématique d'un procédé de formation d'un contact électrique sur une structure selon un mode de réalisation de l'invention,
- la figure 4 est une représentation schématique d'un faisceau de nanotubes de carbone,
- la figure 5 présente la résistance R, en kQ, (sur l'axe vertical) d'un faisceau de nanotube de carbone en fonction de la longueur l, en µm, (sur l'axe horizontal) de ce même faisceau de nanotubes de carbone, la première courbe A est relative aux résultats obtenus avec le procédé selon l'invention, tandis que la courbe B est relative aux résultats obtenus avec une procédé connu de l'état de la technique,
- la figure 6 est une représentation schématique d'un autre exemple de réalisation d'un contact électrique sur une structure.

### EXPOSÉ DÉTAILLÉ DE MODES DE RÉALISATION PARTICULIERS

L'invention décrite de manière détaillée ci-dessous met en oeuvre une étape de formation d'une électrode sur une structure suivie d'une étape d'implantation d'espèces X au travers de ladite électrode conductrice. Il apparaitra clairement dans la description détaillée que l'ordre d'exécution de ces deux étapes est essentiel pour assurer un contact électrique entre l'électrode conductrice et la structure de faible résistance en premier lieu. En second lieu, nous verrons également que la présence de l'électrode conductrice a un effet de protection de la structure lors de l'étape d'implantation.

Pour les différents modes de mise en oeuvre, les mêmes références seront utilisées pour des éléments identiques ou assurant la même fonction, par souci de simplification de la description.

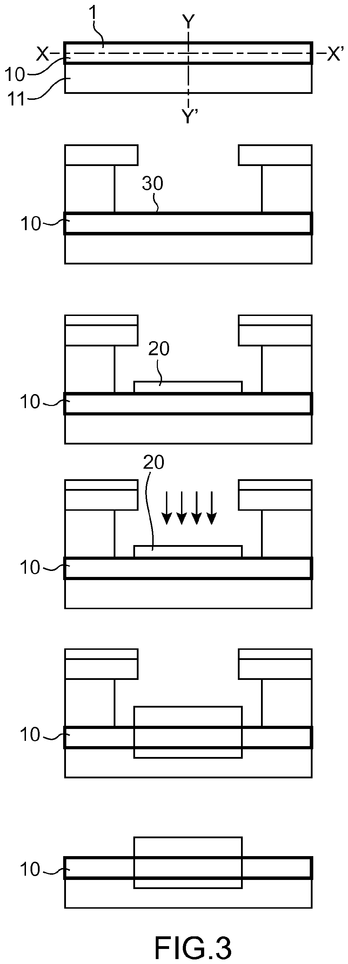

Sur la figure 3, on peut voir un exemple de réalisation du procédé de fabrication d'un contact électrique sur une structure 10.

La structure 10 selon l'invention peut être un composant pour la microélectronique, la photonique, l'optronique, la spintronique, les capteurs, ou encore des électrodes transparentes conductrices.

Par exemple, la structure 10 peut être un transistor, un guide d'onde, une interconnexion horizontale, des dispositifs microélectroniques actifs à nanotubes de carbone, de graphène ou de dichalcogénures de métaux de transition (MoS₂ par exemple), des électrodes transparentes conductrices à base de nanotubes de carbone ou de graphène, des capteurs à base de matériaux anisotropes.

La structure 10 peut reposer sur un support 11, par exemple un substrat de silicium.

La structure 10, selon l'invention est faite d'un matériau anisotrope NA. Le matériau anisotrope NA présente une conductivité électrique anisotrope.

Ainsi, la structure 10 présente une conductivité électrique axiale σ_{//} selon un premier axe XX' d'élongation de ladite structure 10. La structure 10 présente également au moins une conductivité électrique orthogonale σ_{⊥} selon au moins une direction orthogonale YY' au premier axe XX'. L'anisotropie de la conductivité électrique de la structure 10 résulte de l'anisotropie de la conductivité électrique du matériau anisotrope NA.

La structure 10 comprend une première surface 30. La première surface 30 est orthogonale à l'au moins une direction orthogonale YY'.

La structure 10 peut comprendre au moins un des matériaux anisotropes NA choisis parmi : un nanotube de carbone isolé, un faisceau de nanotubes de carbone, du graphène, des dichalcogénures de métaux de transition (par exemple MoS₂, MoSe₂, WS₂, WSe₂), des matériaux 2D, des hétérostuctures de Van der Waals (des empilements de matériaux 2D).

Nous entendons par matériau 2D, un matériau anisotrope constitué d'une seule couche d'atomes ou de molécules présentant une première conductivité électrique selon un plan cristallographique, et une seconde conductivité électrique différente de la première conductivité électrique (par exemple inférieure à la première conductivité électrique) selon une direction perpendiculaire audit plan cristallographique.

Le graphène et les dichalcogénures de métaux de transition sont des exemples de matériaux 2D.

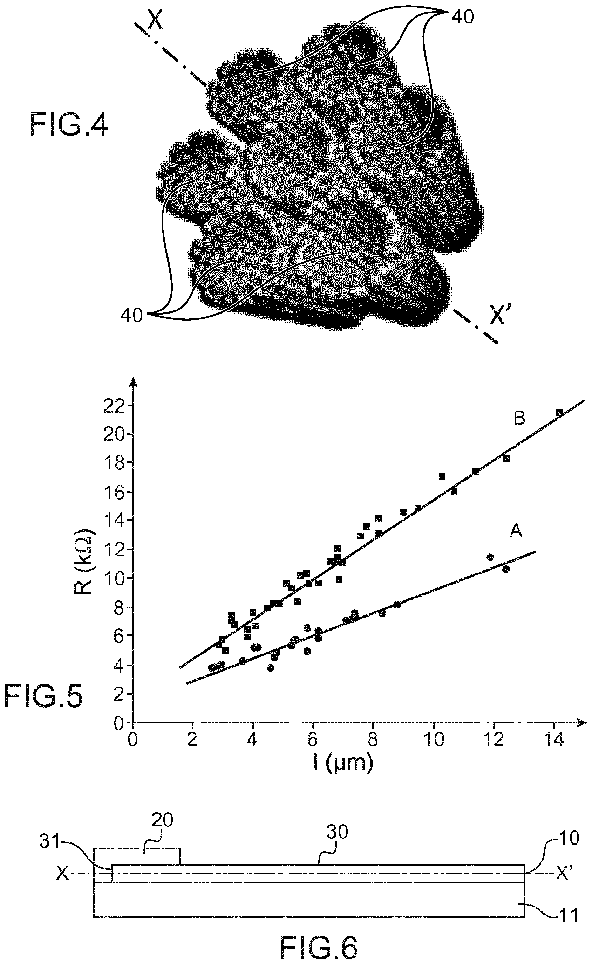

A titre d'exemple, la structure 10 peut être faite d'un faisceau de nanotubes de carbone. Un faisceau de nanotubes de carbone 40 est un arrangement comprenant une pluralité de nanotubes de carbone disposés parallèlement entre eux, et au contact les uns des autres. Dans ce cas de figure, le premier axe XX' de la structure correspond à l'axe d'élongation des nanotubes de carbone formant le faisceau des nanotubes de carbone (figure 4). Le faisceau de nanotubes de carbone comprend une surface latérale, parallèle au premier axe. La surface latérale constitue la première surface 30.

Toujours à titre d'exemple, la structure 10 peut comprendre du graphène. Le graphène est un cristal bidimensionnel (2D) en forme de feuillet. Un feuillet comprend deux faces essentiellement parallèles reliées par une surface latérale. La première surface 30 est une des deux faces du feuillet. La conductivité électrique selon une direction parallèle aux faces du feuillet correspond à la conductivité électrique axial σ_{//}, et est supérieure à la conductivité électrique orthogonale σ_{⊥} selon la direction perpendiculaire aux faces du feuillet. La conductivité électrique axiale σ_{//}, est typiquement 100 à 10000 fois supérieure à la conductivité électrique orthogonale σ_{⊥}.

Le procédé de fabrication d'un contact électrique selon l'invention comprend une étape de formation d'une électrode conductrice 20 d'une épaisseur initiale Eᵢ sur la première surface 30 de la structure 10. L'électrode conductrice 20 comprend une espèce M. Par espèce M, nous entendons espèce chimique M. L'électrode conductrice 20 peut, par exemple, être une électrode métallique, une électrode faite d'un matériau semiconducteur à faible bande interdite (« Gap » selon la terminologie Anglo-Saxonne), une électrode faite d'oxyde conducteur, une électrode faite d'un matériau 2D.

L'espèce M peut comprendre au moins un des éléments choisis parmi : Pd, Au, Ti, Ta, Cr, Al, Mo, Co, W, Ni, Pt, Zr, Nb, Ga, In, Bi.

L'épaisseur initiale Eᵢ de l'électrode conductrice 20 peut être comprise entre 0,1 nm et 50 nm. L'implantation peut être mise en oeuvre sans nécessairement recourir à un amincissement de l'électrode conductrice (par pulvérisation) lors de l'implantation. La gamme d'épaisseurs ainsi proposée permet donc une implantation par recul pour des valeurs raisonnable de dose et d'énergie d'espèces X.

L'électrode conductrice 20 n'est en général formée que sur une partie de la première surface 30, notamment lorsque la structure 10 forme un transistor par exemple. A titre d'exemple, la structure 10 peut comprendre un faisceau de nanotubes de carbone de 115 nm de diamètre. L'électrode conductrice 20 formée sur la structure peut présenter une épaisseur de 10 nm et une largeur de 3 µm.

A cette fin, la formation de l'électrode conductrice 20 peut comprendre les étapes successives suivantes :
1. une étape de photolithographie pour délimiter, à l'aide d'une résine photosensible PR, l'électrode conductrice 20 ;
2. une étape de dépôt d'une espèce M, par un procédé d'évaporation par exemple.

La résine photosensible PR déposée à l'étape 1 peut, avantageusement, être conservée pour la suite du procédé selon l'invention.

Les étapes 1 et 2 de formation de l'électrode conductrice 20 sont des étapes bien connues de l'homme du métier et ne seront pas détaillées dans la description.

L'étape de formation de l'électrode conductrice 20 sur la première surface 30 est suivie d'une étape d'implantation d'espèces X dans l'électrode conductrice 20 et la structure 10. L'étape d'implantation des espèces X peut avantageusement être réalisée exclusivement au travers de l'électrode conductrice 20. Par exemple, un masque présentant une ouverture en correspondance avec l'électrode conductrice 20 peut être disposé sur la structure 10. Par masque, nous entendons une barrière (ou un obstacle) à l'implantation des espèces dans la structure 10. Ainsi, le masque présentant une ouverture en correspondance avec l'électrode conductrice 20 permet de réaliser l'implantation des espèces X exclusivement au travers de l'électrode conductrice 20. De manière avantageuse, la résine photosensible PR délimitant l'électrode conductrice 20 joue également le rôle de masque, de sorte que l'implantation d'espèces X n'est exécutée qu'au travers de l'électrode conductrice 20.

Par implantation d'espèces X dans la structure 10, nous entendons implantation d'espèces X dans le volume de la structure 10.

L'étape d'implantation peut être réalisée à l'aide d'un implanteur ionique adapté pour réaliser un bombardement ionique d'espèces X. Lors de l'étape d'implantation, les espèces X sont accélérées, et ont donc une énergie dite « énergie d'implantation ». L'énergie d'implantation peut être comprise entre 0,1 et 1000 keV. La dose d'espèces X peut être comprise entre 10¹⁰ et 10¹⁸ ions par cm². Les espèces implantées X peuvent comprendre au moins un des éléments choisis parmi : Pd, Au, Ti, Ta, Cr, Al, Mo, Co, W, Ni, Pt, Zr, Nb, Ga, In, Bi, Ar, Kr, Xe, S, Se, Te.

Lors de l'étape d'implantation, les espèces X pénètrent dans le volume de la structure 10 selon une profondeur d'implantation Rp. La profondeur d'implantation dépend des paramètres d'implantation (nature chimique de l'espèce X, énergie d'implantation), mais également de la nature chimique et de l'épaisseur de l'électrode conductrice 20, et de la nature chimique de la structure 10. L'homme du métier est à même de déterminer la profondeur d'implantation Rp.

L'étape d'implantation d'espèces X peut être suivie d'un recuit thermique exécuté à une température comprise entre 300 et 500°C, sous une atmosphère inerte ou réductrice (par exemple sous Argon ou Azote). La durée du recuit peut être comprise entre 30 minutes et 2 heures. Le recuit thermique permet également de réduire la résistance de contact entre la structure 10 et l'électrode conductrice 20.

L'invention ne se limite pas à une étape d'implantation d'espèces X réalisée à l'aide d'un implanteur ionique ou d'un implanteur ionique à immersion plasma. En effet, l'étape d'implantation peut également être mise en oeuvre à l'aide d'un bombardement ionique énergétique réalisée par plasma. En particulier, un plasma radiofréquence à couplage capacitif d'argon à basse pression peut être utilisé, ce dernier présente l'intérêt d'être plus disponible et moins coûteux à opérer qu'un implanteur ionique. A titre d'exemple, un nanotube de carbone multi parois pourra être contacté électriquement avec le procédé selon l'invention en effectuant un traitement plasma de 60 secondes (plasma radiofréquence à couplage capacitif d'argon à 10 mTorr et 600 W de puissance) sur une électrode conductrice 20 de palladium de 3 nm d'épaisseur.

Les inventeurs ont par ailleurs découvert que l'exécution de l'étape d'implantation après la formation de l'électrode conductrice 20 est particulièrement avantageuse et permet de protéger la structure 10. En effet, la structure 10 faite du matériau anisotrope NA peut être dégradée lors de l'étape d'implantation des espèces X.

A cet égard, la Demanderesse a pu constater une destruction complète d'une structure 10 faite de nanotubes de carbone dépourvue de protection (masque et électrode conductrice 20) lors de l'étape d'implantation des espèces X. Ainsi, la présence de l'électrode conductrice 20 permet de protéger les nanotubes de carbone pendant l'étape d'implantation.

De manière particulièrement avantageuse, les espèces X implantées dans la structure peuvent être adaptées pour former des liaisons chimiques avec le matériau anisotrope NA. Ainsi, l'étape d'implantation des espèces X peut avoir deux effets :
A/ une réduction de la barrière tunnel entre l'électrode conductrice 20 et la structure 10.
B/ une déstructuration contrôlée du matériau anisotrope NA formant la structure 10 sous la surface de contact métallique entre l'électrode conductrice 20 et la structure 10 (en figure 3). Ladite déstructuration ouvre la possibilité de former des liaisons chimiques entre les espèces implantées et le matériau anisotrope NA. Ce deuxième effet réduit également, uniquement dans le volume implanté de la structure 10, l'anisotropie de conductivité électrique de la structure 10.

Par ailleurs, et de manière particulièrement avantageuse, l'étape d'implantation d'espèces X peut causer une implantation par recul (« Recoil Implantation » selon la terminologie Anglo-Saxonne) de l'espèce M comprise dans l'électrode conductrice 20.

L'implantation par recul de l'espèce M est induite par le bombardement de l'électrode conductrice 20 par les espèces X lors de l'étape d'implantation. Les atomes M (les espèces M) compris dans l'électrode conductrice 20 sont alors « poussés » dans la structure 10 lors des collisions entre les espèces X et les espèces M. A cet égard, l'homme du métier trouvera une description du phénomène d'implantation par recul dans les documents [8], [9] et [10] cités à la fin de la demande de brevet.

L'épaisseur de l'électrode conductrice 20 et la dose des espèces X implantée seront choisis de façon à s'assurer que l'épaisseur résiduelle de l'électrode conductrice 20 après éventuelle pulvérisation par les espèces X soit telle que l'espèce M, comprise dans l'électrode conductrice 20, puisse être implantée par recul dans la structure 10.

Ainsi, dès lors que l'épaisseur Ei de l'électrode conductrice 20 est comprise entre 0,1 nm et 50 nm, une implantation par recul de l'espèce M dans la structure 10 peut être observée pour des énergies et des doses d'implantation raisonnables.

L'implantation par recul des espèces M dans la structure 10 permet ainsi de créer une interface diffuse entre l'électrode conductrice 20 et la structure 10.

De manière particulièrement avantageuse, l'espèce M est également adaptée pour former des liaisons chimiques avec le matériau anisotrope NA. Ainsi, dès lors que les espèces M sont également implantées par recul dans le matériau NA, la formation de liaisons chimiques entre les espèces M et le matériau NA est possible. Le caractère diffus de l'interface entre l'électrode conductrice 20 et la structure 10 s'en trouve renforcé. Par ailleurs, l'implantation par recul de l'espèce M contribue également à la réduction de l'anisotropie de la conductivité électrique du volume implanté par recul de la structure 10.

Cette réduction de l'anisotropie a pour origine la création de chemins de conduction selon la direction YY' (perpendiculaire à la première surface 30) dans le cas de structures 10 épaisses (exemple faisceau de nanotubes de carbone ou hétérostructures de Van der Waals), et/ou la réduction de la conductivité parallèle σ_{//} sous l'effet de la déstructuration contrôlée de la structure 10. L'implantation par recul pourra être mise en oeuvre dès lors que l'épaisseur de l'électrode conductrice 20 devient comparable ou inférieure à la profondeur de pénétration des espèces X dans ladite électrode conductrice 20. Cette profondeur de pénétration est connue par l'homme de métier pour les différents couples d'espèces M/X en fonction de l'énergie d'implantation des espèces X.

De manière particulièrement avantageuse, et puisque l'épaisseur de l'électrode conductrice 20 après implantation peut être différente de l'épaisseur initiale Eᵢ de ladite électrode conductrice 20 :
- l'énergie d'implantation des espèces X peut être suffisamment importante pour que les espèces X puissent traverser toute l'épaisseur de la structure 10 en l'absence d'électrode conductrice 20,
- et l'épaisseur de l'électrode conductrice 20 et la dose d'espèces X implantée peuvent être choisies de façon à s'assurer que l'épaisseur restante de l'électrode conductrice 20 après éventuelle pulvérisation par les espèces X soit telle que l'espèce M puisse être implanté par recul dans la structure 10.

De manière particulièrement avantageuse, les espèces X et les espèces M sont de même nature chimique, avantageusement, elles sont identiques. En pareil cas, une implantation par recul des espèces M comprises dans l'électrode conductrice 20 peut aussi être observée.

A titre d'exemple, une implantation par recul d'atomes de Pd d'une électrode conductrice 20 de Pd de 10 nm d'épaisseur initiale pourra être observée dans un faisceau de nanotubes de carbone si l'étape d'implantation comprend l'implantation d'ions Pd à une énergie d'implantation de 30 keV et une dose de 4.10¹⁵ ions/cm².

L'étape d'implantation des espèces X peut pulvériser, au moins partiellement, l'électrode conductrice 20. Ainsi, l'étape d'implantation des espèces X peut être exécutée de sorte qu'à l'issue de ladite étape, l'électrode conductrice 20 présente une épaisseur résiduelle non nulle et inférieure à l'épaisseur initiale Eᵢ. L'homme du métier peut sans problème déterminer les conditions d'implantation des espèces X et/ou l'épaisseur initiale Eᵢ permettant d'atteindre ce résultat.

L'étape d'implantation peut également être suivie d'une étape d'épaississement de l'électrode conductrice 20. Une électrode conductrice 20, faite de palladium par exemple, peut présenter une épaisseur 2 nm après l'étape d'implantation. L'épaississement peut alors comprendre un dépôt d'une couche de palladium (40 nm par exemple), et un dépôt d'une couche de d'or (150 nm par exemple).

Tout au long du procédé selon l'invention, la résine photosensible PR, délimitant l'électrode conductrice 20 peut être conservée. Ainsi, la résine photosensible PR constitue un masque permettant de délimiter l'implantation au travers de l'électrode conductrice 20 uniquement et de protéger le reste de la structure 10 du bombardement ionique direct de X. L'homme de métier saura s'assurer que l'épaisseur de résine photosensible PR est suffisante à cet égard.

Dans ce cas de figure, la résine photosensible PR est retirée à la toute fin du procédé selon l'invention (mais avant l'éventuel recuit).

Dans la suite de l'énoncé, nous présentons trois exemples de mise en oeuvre de l'invention.

Selon un premier exemple, la structure 10 comprend donc un faisceau de nanotube de carbone de 115 nm de diamètre. Le faisceau de nanotube de carbone comprend plusieurs centaines de nanotube de carbones d'environ 4,5 nm de diamètre, et comprenant, chacun, environ 3 parois. Le faisceau repose sur une couche de dioxyde de silicium formée sur un substrat de silicium. Une électrode conductrice 20 de Palladium (Pd) et de 10 nm d'épaisseur initiale est formée selon le procédé illustré à la figure 3. La formation de l'électrode conductrice 20 est suivie d'une étape d'implantation d'atomes d'or avec une énergie d'implantation de 30 keV, et une dose de 10¹⁶ ions par cm². L'étape d'implantation est alors suivie d'un épaississement de l'électrode conductrice 20. L'épaississement comprend le dépôt de 40 nm de palladium et de 150 nm d'or. La figure 5 présente la résistance R du faisceau de nanotubes (sur l'axe vertical) en fonction de la longueur l (sur l'axe horizontal) de ce même faisceau de nanotubes de carbone. Une première courbe A est relative aux résultats obtenus avec le procédé selon l'invention. La courbe B est relative aux résultats obtenus avec un procédé connu de l'état de la technique.

Le procédé selon l'invention permet ainsi d'augmenter de 70% la proportion de nanotubes de carbone électriquement connectés à l'électrode conductrice 20.

Selon un deuxième exemple, la structure 10 comprend une monocouche de graphène disposée sur une couche de dioxyde de silicium formée sur un substrat de silicium. L'électrode conductrice 20 comprend, dans cet exemple, et avant l'étape d'implantation d'espèces X, une couche de palladium de 7 nm d'épaisseur. L'étape d'implantation des espèces X est réalisée à une énergie d'implantation de 10 keV, et une dose de 10¹⁴ cm⁻² d'atomes de palladium. Pour ce second exemple, le contact électrique peut notamment être réalisé via l'implantation d'ions palladium (Pd) à 10 keV, avec une dose de 10¹⁴ ions par cm² dans une couche M de 7 nm de Pd.

Selon un troisième exemple présenté à la figure 6, l'électrode conductrice 20 est réalisée de façon contiguë à un contact par la tranche (en recouvrement d'une surface 31 de la structure 10, la surface 31 étant perpendiculaire à la direction XX') avec le procédé décrit dans le premier exemple de façon à réaliser un contact mixte tranche plus dessus.

Le procédé selon l'invention permet alors de former un contact électrique sur une structure 10, faite d'un matériau anisotrope, présentant une résistance de contact électrique faible.

Par ailleurs, le procédé proposé par les inventeurs est plus facile à mettre en oeuvre qu'un contact par la tranche.

En outre, le procédé selon l'invention est moins sensible aux contaminants (et plus particulièrement aux contaminants carbonés très présents sur les structures 10 faite par exemple de nanotube de carbone ou de graphène). Par conséquent, le procédé est moins exigeant en terme de nettoyage par rapport aux procédés de la microélectronique.

### RÉFÉRENCES

[1] Adrien Allain et al., « Electrical contacts to two-dimensional semiconductors » Nature Materials, 14, 1195-1205, (2015),
[2] US 2013/0059134,
[3] Debdeep Jena et al., "2D crystal semiconductors: Intimate contacts", Nature Materials 13, 1076 (2014),
[4] Jiahao Kang, "High-performance MoS2 transistors with low-resistance molybdenum contacts", Applied Physics Letters 104, 093106 (2014),
[5] Joshua T. Smith et al., "Reducing Contact Résistance in Graphene Devices through Contact Area Patterning", ACS Nano, 2013, 7 (4), pp 3661-3667,
[6] Wei Sun Leong et al., "Low-Contact-Resistance Graphene Devices with Nickel-Etched-Graphene Contacts", ACS Nano, 2014, 8 (1), pp 994-1001,
[7] Joshua A. Robinson et al., "Contacting graphene", Appl. Phys. Lett. 98, 053103 (2011),
[8] EP 0 067 090 B1,
[9] Nelson R.S., "The theory of recoil implantation", Radiation effects 2, 47 (1969),
[10] Dearnaley G., "Bombardment-diffused coatings and ion beam mixing", Radiation effects 63, 25 (1982).

## Revendications

1. Procédé de fabrication d'un contact électrique sur une structure (10) faite d'un matériau anisotrope NA présentant une conductivité électrique anisotrope, la structure (10) présentant une conductivité électrique axiale σ_{//} selon un premier axe XX' de la structure (10), et au moins une conductivité électrique orthogonale σ_{⊥} selon au moins une direction orthogonale YY' au premier axe XX' de la structure (10), l'au moins une conductivité électrique orthogonale σ_{⊥} étant inférieure à la conductivité électrique axiale σ_{//}, le procédé comprenant :
- une étape de formation d'une électrode conductrice (20), d'une épaisseur initiale Ei, comprenant au moins une espèce M, sur une première surface (30) de la structure (10), la première surface (30) étant orthogonale à l'au moins une direction orthogonale YY' ;
le procédé étant **caractérisé en ce que** l'étape de formation de l'électrode conductrice (20) est suivie d'une étape d'implantation d'espèces X, au travers de l'électrode conductrice (20), dans la structure (10).

2. Procédé selon la revendication 1, dans lequel l'étape d'implantation des espèces X est réalisée exclusivement au travers de l'électrode conductrice (20), avantageusement un masque présentant une ouverture en correspondance avec l'électrode conductrice (20) est disposé sur la structure (10) pendant l'étape d'implantation des espèces X.

3. Procédé selon la revendication 1 ou 2, dans lequel l'espèce M est implantée par recul dans la structure (10) lors de l'étape d'implantation d'espèces X.

4. Procédé selon l'une des revendications 1 à3, dans lequel l'espèce M est adaptée pour former des liaisons chimiques avec le matériau anisotrope NA.

5. Procédé selon l'une des revendications 1 à 4, dans lequel les espèces X sont adaptées pour former des liaisons chimiques avec le matériau anisotrope NA.

6. Procédé selon l'une des revendications 1 à 5, dans lequel les espèces X et l'espèce M sont de même nature chimique, avantageusement identiques

7. Procédé selon l'une des revendications 1 à 6, dans lequel l'étape d'implantation est exécutée selon une énergie d'implantation des espèces X, conférant auxdites espèces X une énergie suffisante pour traverser la structure (10), lorsqu'elle est dépourvue d'électrode conductrice (20), dans son intégralité au travers de la première surface (30), et selon une direction orthogonale YY' à ladite première surface (30).

8. Procédé selon l'une des revendications 1 à 7, dans lequel l'étape d'implantation des espèces X est exécutée de sorte qu'à l'issue de ladite étape, l'électrode conductrice (20) présente une épaisseur résiduelle non nulle, et inférieure à l'épaisseur initiale Ei et à la profondeur d'implantation Rp des espèces X dans l'électrode conductrice (20)

9. Procédé selon l'une des revendications 1 à 8, dans lequel l'étape d'implantation des espèces X est suivie d'une étape comprenant l'épaississement de l'électrode conductrice (20).

10. Procédé selon l'une des revendications 1 à 9, dans lequel le matériaux anisotrope NA comprend au moins un des matériaux choisi parmi : un nanotube de carbone isolé, un faisceau de nanotubes de carbone, du graphène, de dichalcogénures de métaux de transition, des matériaux 2D, des hétérostructures de Van der Waals.

11. Procédé selon l'une des revendications 1 à 10, dans lequel l'espèce M comprend au moins un des éléments choisis parmi : Pd, Au, Ti, Ta, Cr, Al, Mo, Co, W, Ni, Pt, Zr, Nb, Ga, In, Bi.

12. Procédé selon l'une des revendications 1 à 11, dans lequel l'épaisseur initiale Ei est comprise entre 0,1 nm et 50 nm

13. Procédé selon l'une des revendications 1 à 12, dans lequel les espèces implantées X comprennent au moins un des éléments choisis parmi : Pd, Au, Ti, Ta, Cr, Al, Mo, Co, W, Ni, Pt, Zr, Nb, Ga, In, Bi, Ar, Kr, Xe, S, Se, Te.

14. Procédé selon l'une des revendications 1 à 13, dans lequel l'étape d'implantation des espèces X est réalisée à une énergie d'implantation comprise entre 0,1 et 1000 keV.

15. Procédé selon l'une des revendications 1 à 14, dans lequel l'étape d'implantation des espèces X est réalisée selon une dose d'espèces X comprise entre 10¹⁰ et 10¹⁸ ions par cm².

16. Procédé selon l'une des revendications 1 à 15, dans lequel l'étape d'implantation des espèces X est suivie d'un recuit thermique exécuté à une température comprise entre 300 et 500°C, sous une atmosphère inerte ou réductrice.

## Patentansprüche

1. Verfahren zur Herstellung eines elektrischen Kontakts auf einer Struktur (10), die aus einem anisotropen Material NA hergestellt ist, das eine anisotrope elektrische Leitfähigkeit aufweist, wobei die Struktur (10) eine axiale elektrische Leitfähigkeit *σ*_{||} entlang einer ersten Achse XX' der Struktur (10) und wenigstens eine orthogonale elektrische Leitfähigkeit *σ*_{⊥} entlang wenigstens einer Richtung YY' orthogonal zur ersten Achse XX' der Struktur (10) aufweist, wobei die wenigstens eine orthogonale elektrische Leitfähigkeit *σ*_{⊥} kleiner ist als die axiale elektrische Leitfähigkeit *σ*_{||}, wobei das Verfahren Folgendes umfasst:
- einen Schritt des Bildens einer leitenden Elektrode (20) mit einer anfänglichen Dicke Ei, umfassend wenigstens eine Sorte M, auf einer ersten Oberfläche (30) der Struktur (10), wobei die erste Oberfläche (30) orthogonal zu der wenigstens einen orthogonalen Richtung YY' ist;
wobei das Verfahren **dadurch gekennzeichnet ist, dass** auf den Schritt des Bildens der leitenden Elektrode (20) ein Schritt des Implantierens von Sorten X durch die leitende Elektrode (20) hindurch in die Struktur (10) folgt.

2. Verfahren nach Anspruch 1, bei dem der Schritt des Implantierens der Sorten X ausschließlich durch die leitende Elektrode (20) hindurch realisiert wird, wobei vorzugsweise eine Maske, die eine Öffnung in Übereinstimmung mit der leitenden Elektrode (20) aufweist, auf der Struktur (10) während des Schritts des Implantierens der Sorten X angeordnet ist.

3. Verfahren nach Anspruch 1 oder 2, bei dem die Sorte M durch Rückstoss in der Struktur (10) während des Schritts des Implantierens von Sorten X implantiert wird.

4. Verfahren nach einem der Ansprüche 1 bis 3, bei dem die Sorte M dazu ausgelegt ist, chemische Verbindungen mit dem anisotropen Material NA zu bilden.

5. Verfahren nach einem der Ansprüche 1 bis 4, bei dem die Sorten X dazu ausgelegt sind, chemische Verbindungen mit dem anisotropen Material NA zu bilden.

6. Verfahren nach einem der Ansprüche 1 bis 5, bei dem die Sorten X und die Sorte M von gleicher chemischer Natur sind, vorzugsweise identisch.

7. Verfahren nach einem der Ansprüche 1 bis 6, bei dem der Schritt des Implantierens gemäß einer Implantierungsenergie der Sorten X ausgeführt wird, die den Sorten X eine ausreichende Energie verleiht, um die Struktur (10), wenn sie ohne leitende Elektrode (20) ist, zur Gänze durch die erste Oberfläche (30) hindurch und entlang einer Richtung YY' orthogonal zu der ersten Oberfläche (30) zu durchsetzen.

8. Verfahren nach einem der Ansprüche 1 bis 7, bei dem der Schritt des Implantierens der Sorten X derart ausgeführt wird, dass am Ende dieses Schritts die leitende Elektrode (20) eine Restdicke ungleich Null und kleiner als die anfängliche Dicke Ei und die Implantierungstiefe Rp der Sorten X in der leitenden Elektrode (20) aufweist.

9. Verfahren nach einem der Ansprüche 1 bis 8, bei dem auf den Schritt des Implantierens der Sorten X ein Schritt folgt, der ein Verdicken der leitenden Elektrode (20) umfasst.

10. Verfahren nach einem der Ansprüche 1 bis 9, bei dem das anisotrope Material NA wenigstens eines der Materialien umfasst, ausgewählt aus Folgenden: ein isoliertes Kohlenstoffnanoröhrchen, ein Bündel von Kohlenstoffnanoröhrchen, Graphen, Dichalkogenide von Übergangsmetallen, 2D-Materialien, Van der Waals-Heterostrukturen.

11. Verfahren nach einem der Ansprüche 1 bis 10, bei dem die Sorte M wenigstens eines der Elemente umfasst, ausgewählt aus: Pd, Au, Ti, Ta, Cr, Al, Mo, Co, W, Ni, Pt, Zr, Nb, Ga, In, Bi.

12. Verfahren nach einem der Ansprüche 1 bis 11, bei dem die anfängliche Dicke Ei zwischen 0,1 nm und 50 nm enthalten ist.

13. Verfahren nach einem der Ansprüche 1 bis 12, bei dem die implantierten Sorten X wenigstens eines der Elemente umfassen, ausgewählt aus: Pd, Au, Ti, Ta, Cr, Al, Mo, Co, W, Ni, Pt, Zr, Nb, Ga, In, Bi, Ar, Kr, Xe, S, Se, Te.

14. Verfahren nach einem der Ansprüche 1 bis 13, bei dem der Schritt des Implantierens der Sorten X bei einer Implantierungsenergie realisiert wird, die zwischen 0,1 und 1000 keV enthalten ist.

15. Verfahren nach einem der Ansprüche 1 bis 14, bei dem der Schritt des Implantierens der Sorten X gemäß einer Dosis von Sorten X realisiert wird, die zwischen 10¹⁰ und 10¹⁸ Ionen pro cm² enthalten ist.

16. Verfahren nach einem der Ansprüche 1 bis 15, bei dem auf den Schritt des Implantierens der Sorten X ein thermisches Glühen erfolgt, das bei einer Temperatur ausgeführt wird, die zwischen 300 und 500°C enthalten ist, unter einer Inert- oder Reduktionsatmosphäre.

## Claims

1. Method for manufacture of an electrical contact on a structure (10) made of an anisotropic material NA which exhibits an anisotropic electrical conductivity, where the structure (10) exhibits an axial electrical conductivity σ_{//} along a first axis XX' of the structure (10) and at least one orthogonal electrical conductivity σ_{⊥} along at least one direction YY' orthogonal to the first axis XX' of the structure (10), where the at least one electrical conductivities σ_{⊥} are less than the axial electrical conductivity σ_{//}, where the method comprises:
- a step for the formation of a conductive electrode (20), with an initial thickness Ei, comprising at least one species M, on a first surface (30) of the structure (10), where the first surface (30) is orthogonal to the at least one directions YY';
the method being **characterized in that** the step for the formation of the conductive electrode (20) is followed by a step for implantation of species X through the conductive electrode (20), into the structure (10).

2. Method according to claim 1, wherein the step for implantation of the species X is carried out solely through the conductive electrode (20), advantageously a mask which offers an opening which corresponds to the conductive electrode (20) is arranged on the structure (10) before the step for implantation of the species X.

3. Method according to claim 1 or 2, wherein the species M is implanted by recoil into the structure (10) during the step for implantation of the species X.

4. Method according to one of claims 1 to 3, wherein the species M is adapted to form chemical bonds with the anisotropic material NA.

5. Method according to one of claims 1 to 4, wherein the species X are adapted to form chemical bonds with the anisotropic material NA.

6. Method according to one of claims 1 to 5, wherein the species X and the species M are of the same chemical nature, advantageously identical.

7. Method according to one of claims 1 to 6, wherein the implantation step is carried out using an implantation energy of the species X which confers upon the species X sufficient energy to pass through the structure (10), when it is without the conductive electrode (10), in its entirety through the first surface (30) and along a direction YY' orthogonal to said first surface (30).

8. Method according to one of claims 1 to 7, wherein the step for implantation of the species X is carried out in such a way that at the end of said step the conductive electrode (20) exhibits a non-zero residual thickness which is less than the initial thickness Ei and than the implantation depth Rp of the species X in the conductive electrode (20).

9. Method according to one of claims 1 to 8, wherein the step for implantation of species X is followed by a step comprising thickening of the electrode (20).

10. Method according to one of claims 1 to 9, wherein the anisotropic material NA comprises one or more materials chosen from amongst: an insulated carbon nanotube, a bundle of carbon nanotubes, graphene, transition metal dichalcogenides, 2D materials, Van der Waals heterostructures.

11. Method according to one of claims 1 to 10, wherein the species M comprises at least one of the elements chosen from amongst: Pd, Au, Ti, Ta, Cr, Al, Mo, Co, W, Ni, Pt, Zr, Nb, Ga, In, Bi.

12. Method according to one of claims 1 to 11, wherein the initial thickness Ei is between 0.1 nm and 50 nm.

13. Method according to one of claims 1 to 12, wherein the implanted species X comprise at least one of the elements chosen from amongst: Pd, Au, Ti, Ta, Cr, Al, Mo, Co, W, Ni, Pt, Zr, Nb, Ga, In, Bi, Ar, Kr, Xe, S, Se, Te.

14. Method according to one of claims 1 to 13, wherein the step for implantation of species X is carried out at an implantation energy of between 0.1 and 1000 keV.

15. Method according to one of claims 1 to 14, wherein the step for implantation of species X is carried out in accordance with a dose of species X of between 10¹⁰ and 10¹⁸ ions per cm².

16. Method according to one of claims 1 to 16, wherein the step for implantation of species X is followed by thermal annealing carried out at a temperature of between 300 and 500°C, in an inert or reducing atmosphere.
